# EUROPÄISCHE PATENTANMELDUNG

(11) **EP 2 276 330 A2**
(43) Veröffentlichungstag der Anmeldung: **19.01.2011**
(21) Anmeldenummer: 10405120.6
(22) Anmeldetag: 22.06.2010
(51) Int. Cl.: H05K 5/00, F15B 15/28

(54) **Gehäusewand für die Befestigung eines Gerätes an einer Maschine**

(30) Priorität: 16.07.2009 CH 11112009
(71) Anmelder: Kunststoff Schwanden AG, 8762 Schwanden (CH)
(72) Erfinder: Küsperth, Josef, 8762 Schwanden (CH); Schaufelberger, Martin, 8872 Weesen (CH)
(74) Vertreter: Quehl, Horst Max

(57) **Zusammenfassung**

Eine an einem Maschinengehäuse befestigbare Gehäusewand (1) dient der Anbringung eines elektrisch, pneumatische oder hydraulisch wirkenden Gerätes (6) an einer Maschine und steht hierzu mit einem das Gerät (6) sicher einschliessenden Geräteträger (7) in dichter und rüttelfester Verbindung. Hierzu dienen seitliche Riegel (24), die bajonettverschlussartig in Riegelaufnahmen (23) der Gehäusewand (1) eingreifen. Die Einheit aus Gehäusewand (1) und Geräteträger (7) ist kostengünstig in Kunststoffspritztechnik herstellbar und hat eine geringe Bauhöhe, so dass sie besonders für den Einbau in den Motorraum eines Fahrzeuges geeignet ist.

## Beschreibung

Die Erfindung betrifft eine Gehäusewand für die Befestigung eines Gerätes an einer Maschine, mit einem das Gerät einschliessenden Geräteträger, mit mindestens einem an diesem angeformten Anschlussstutzen, für elektrische, pneumatische oder hydraulische Anschlüsse vom Gerät nach aussen und mit seitlichen Fortsätzen, für eine rüttelfeste mechanische Verbindung des Geräteträgers mit der Gehäusewand.

Um Geräte, wie z.B. Stellantriebe (actuators) oder Signalgeber (sensors) aussen an einer Maschine vorzusehen, wie es beispielsweise für einen hydraulischen Stellantrieb durch die EP 1079078 bekannt ist, werden diese üblicherweise von einem für deren Herstellung spezialisierten Zulieferer derart bereitgestellt, dass sie funktionssicher geschützt in einem z.B. kapselförmigen, metallischen Geräteträger eingeschlossen sind. An dem Geräteträger angeformte flanschbildende Fortsätze mit Schraubenlöchern ermöglichen es dem Maschinenmonteur, das Gerät an eine Gehäusewand der Maschine abgedichtet und rüttelfest anzuschrauben.

Da eine solche Befestigungsart ihre Verspannung erfordert, ist eine hierzu ausreichende Schraubenlänge mit ausreichend langem Gewindeeingriff in der Gehäusewand erforderlich, der in Aluminium-Druckguss mindestens dem Schraubendurchmesser und in Kunststoff mindestens dem doppelten Schraubendurchmesser entsprechen muss. Falls der Geräteträger mit angeformtem Flansch, entsprechend einer Zielsetzung der Erfindung, aus Kunststoff gefertigt werden soll, sind ausserdem im Flansch vorgesehene Aufnahmelöcher für Schrauben mit Ausgleichsbuchsen (compression iimiter^{®}) auszukleiden, um eine Lockerung der Verbindung durch Kaltfluss des Kunststoffmaterials zu verhindern. Ausserdem ist es aufwendig, die in der Gehäusewand vorzusehenden Gewindebohrungen in einem Sackloch auszuführen oder auf andere aufwendige Art Massnahmen für die Abdichtung im Bereich solcher Schraubverbindungen zu treffen. Zur raumsparenden Herstellung wurden aus diesen Gründen solche Gehäusewände, wie sie z.B. als Verschlusswand für den Kettenkasten einer Hubkolbenmaschine verwendet werden, bisher aus Aluminium-Druckguss hergestellt, mit dem zusätzlichen Nachteil, dass diese Herstellungsweise eine spanabhebende Nachbearbeitung des Gussrohlings erfordert.

Der Erfindung liegt die Aufgabe zugrunde, eine Gehäusewand der eingangs genannten Art zu finden, die ebenso wie ihr Geräteträger auf einfache und kostengünstige Weise im Kunststoffspritzverfahren herstellbar ist, die für ihre Montage an einer Maschine dennoch wenig Raum beansprucht und die auf einfache Weise und mit zeitsparender Montagearbeit die Herstellung einer dichten und rüttelfesten Verbindung mit dem Geräteträger ermöglicht, so dass sie besonders vorteilhaft auch für Anwendungen im Motorraum eines Kraftfahrzeuges geeignet ist.

Die Lösung dieser Aufgabe erfolgt erfindungsgemäss aufgrund der Merkmale des Patentanspruchs 1. Vorteilhafte Ausgestaltungen der Erfindung sind Gegenstand der abhängigen Patentansprüche und der folgenden Beschreibung anhand der Zeichnungen zu entnehmen. Es zeigt:
Fig.1 und Fig.2 eine Gegenüberstellung von Teilquerschnitten je einer vorbekannten und einer erfindungsgemässen Gehäusewand mit Geräteträger,
Fig.3 eine perspektivische Darstellung der Gehäusewand nach Fig.2,
Fig. 4 eine Querschnittsdarstellung der Gehäusewand nach Fig.3 entlang der Linie V-V der Fig.5,
Fig.6 eine Querschnittsdarstellung entlang der Linie VI-VI der Fig.5 mit dem bajonettverschlussartigen Eingriff in vergrösserter Darstellung,
Fig.7 einen vergrösserten Teilquerschnitt der Gehäusewand im Bereich einer Verdrehsicherung mittels eines Sicherungszapfens,
Fig.8 eine perspektivische Teildarstellung im Bereich des Sicherungszapfens nach Fig.2 in Ausgangs- und Endposition,
Fig. 9 einen Axialschnitt durch eine Gehäusewand mit verriegeltem Geräteträger,
Fig.10 einen vergrösserten Teilquerschnitt im Bereich IX der Fig.9, zur Darstellung einer nockenartigen Verdrehsicherung des Geräteträgers,
Fig.11 einen Axialschnitt durch eine Gehäusewand mit sägezahnartiger Drehsicherung des verriegelten Geräteträgers,
Fig.12 einen vergrösserten Teilquerschnitt im Bereich XI der Fig.11, zur Darstellung einer sägezahnartigen Verdrehsicherung des Geräteträgers,
Fig.13 eine perspektivische Ansicht der Aussenseite einer deckelartigen Gehäusewand mit zwei Geräteträgern und
Fig.14 eine perspektivische Ansicht der Innenseite der Gehäusewand nach Fig.13.

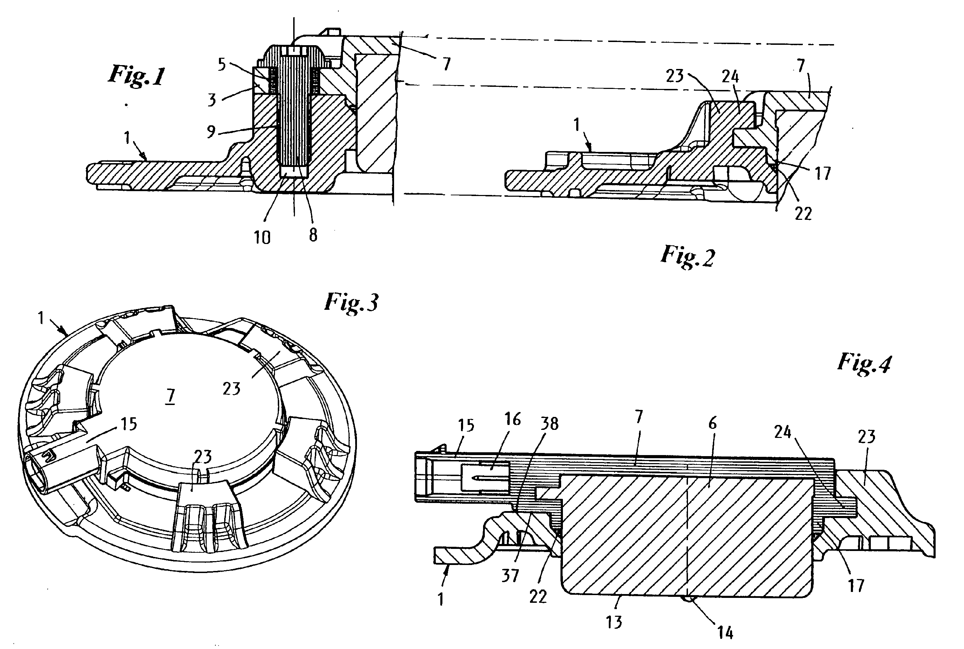

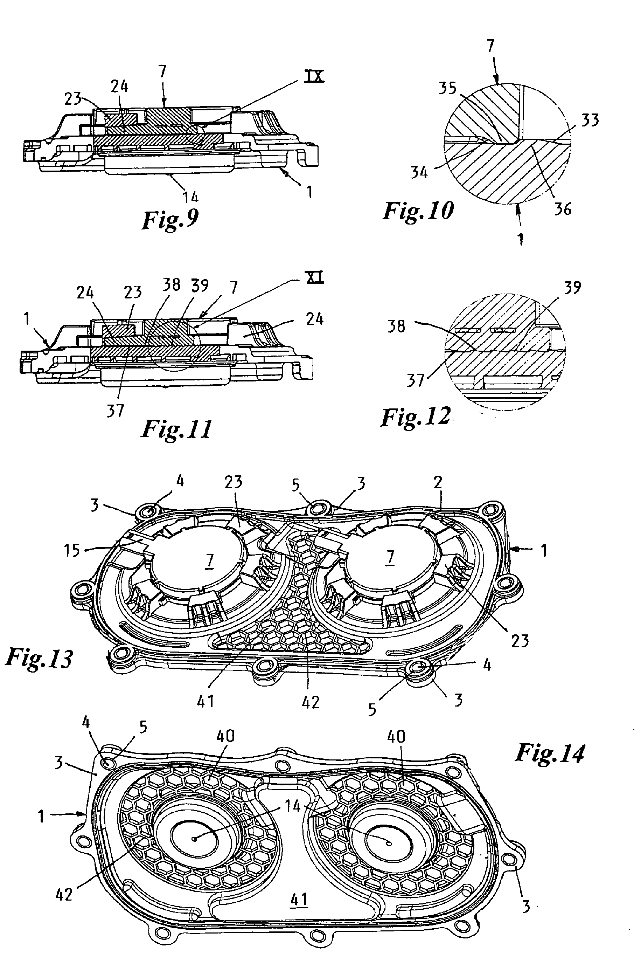

Das in den Zeichnungen mit mehreren Varianten einer Verdrehsicherung dargestellte Ausführungsbeispiel der Erfindung bezieht sich auf eine in Fig.13 und 14 gesamthaft dargestellte, in Kunststoffspritztechnik hergestellte Gehäusewand 1, welche die deckelartige Verschlusswand eines nichtdargestellten Kettenkastens des Nockenwellenantriebs einer Hubkolbenmaschine bildet. Entlang des äusseren Randes 2 der Gehäusewand 1 verteilt sind mehrere flanschartige Fortsätze 3 mit Aufnahmebohrungen 4 für nichtdargestellte Befestigungsschrauben angeformt, deren Gewinde in Gewindebohrungen des metallischen Maschinengehäuse ausreichend tiefen Eingriff finden können, um eine rüttelfeste Schraubverspannung zu erhalten. Um dabei eine Kompression des Kunststoffmaterials der Gehäusewand im Bereich dieser flanschartigen Fortsätze 3 zu vermeiden, werden die Kräfte der Schraubverspannung durch dort eingegossene oder montierte Ausgleichsbuchsen 5 (compression limiter^{®}) aufgenommen, wie in Fig.1 und Fig.13, 14 gezeigt ist.

Wie eingangs dargelegt, wurde entsprechend dem Stand der Technik, wie er in Fig.1 gezeigt ist, eine derartige Schraubverbindung mit Ausgleichsbuchsen 5 in entsprechender Weise auch für eine rüttelfeste Verbindung eines ein Gerät 6 einschliessenden Geräteträgers 7 mit einer Gehäusewand 1 verwendet, das z.B. aus einem elektromagnetischen Stellantrieb 6 besteht. Dies führte jedoch dazu, dass eine ausreichende Länge für den Gewindeeingriff der Schraube 8 eine entsprechende Dicke der Gehäusewand 1 mit folglich grossem Materialaufwand erforderte. Hinzu kommt, dass die Herstellung des Gewindes 9 in einem Sackloch 10, z.B. durch Einmontieren einer Gewindebuchse, aufwendig ist. Ein weiterer wesentlicher Nachteil ist dadurch gegeben, dass solch eine dicke Gehäusewand 1 zur Länge einer mit ihr ausgerüsteten Hubkolbenmaschine beiträgt, mit entsprechenden Folgen, z.B. für die Gesamtlänge eines mit einer solchen Maschine ausgerüsteten Fahrzeuges. Die aufgrund der Erfindung sich ergebende, wesentlich geringere Bauhöhe oder Dicke der Gehäusewand 1 mit Geräteträger 7 ist durch die im gleichen Massstab in Fig.1 und Fig.2 nebeneinander angeordneten Querschnittsdarstellungen ersichtlich.

Entsprechend dem dargestellten, erfindungsgemässen Ausführungsbeispiel ist in dem mit der Gehäusewand 1 verbundenen Geräteträger 7 ein elektromagnetischer Stellantrieb 6 herstellungsgemäss z.B. durch Umspritzen mit Kunststoffmaterial fest eingeschlossen. Der Stellantrieb 6 hat einen durch das Feld einer elektrischen Erregerspule 11 axial beweglichen, kreisrunden Magnetkern 12 und dient der Steuerung der axialen Position einer nichtdargestellten Nockenwelle, zur Erzielung einer vom Betriebszustand einer Hubkolbenmaschine abhängigen, optimalen Eingriffsposition ihrer Nocken, wie es prinzipiell durch die eingangs genannte EP 1079078 bekannt ist. Eine zentral an der Stirnfläche 13 des Magnetkerns 12 vorgesehene Kontaktspitze 14 überträgt die axiale Schubkraft des Stellantriebs 6 mit somit minimaler Reibung auf die Mitte der nichtdargestellten Endfläche der betreffenden Nockenwelle. Die für die Stromzufuhr zur Erregerspule 11 erforderlichen, nicht dargestellten elektrischen Kabel sind in einem seitlichen Anschlussstutzen 15 des jeweiligen Geräteträgers 7 eingeschlossen und können in diesem einen Verbindungsstecker 16 aufweisen.

Für die Zentrierung des Geräteträgers 7 greift dieser mit einem kurzen, ringförmig umlaufenden Zentrierrand 17 in eine kreisrunde Aufnahmeöffnung 18 der Gehäusewand 1 ein, die über eine Abschrägung 19 in eine Innenöffnung 20 übergeht, mit der die Gehäusewand 1 das Spulengehäuse 21 der Erregerspule 11 umschliesst.

In die Aufnahmeöffnung 18 ist ein z.B. als O-Ring 22 ausgeführter Dichtring eingesetzt, so dass dieser zwischen der Abschrägung 19, dem Spulengehäuse 21 und der Stirnfläche des Zentrierrandes 17 dichtend eingeschlossen ist.

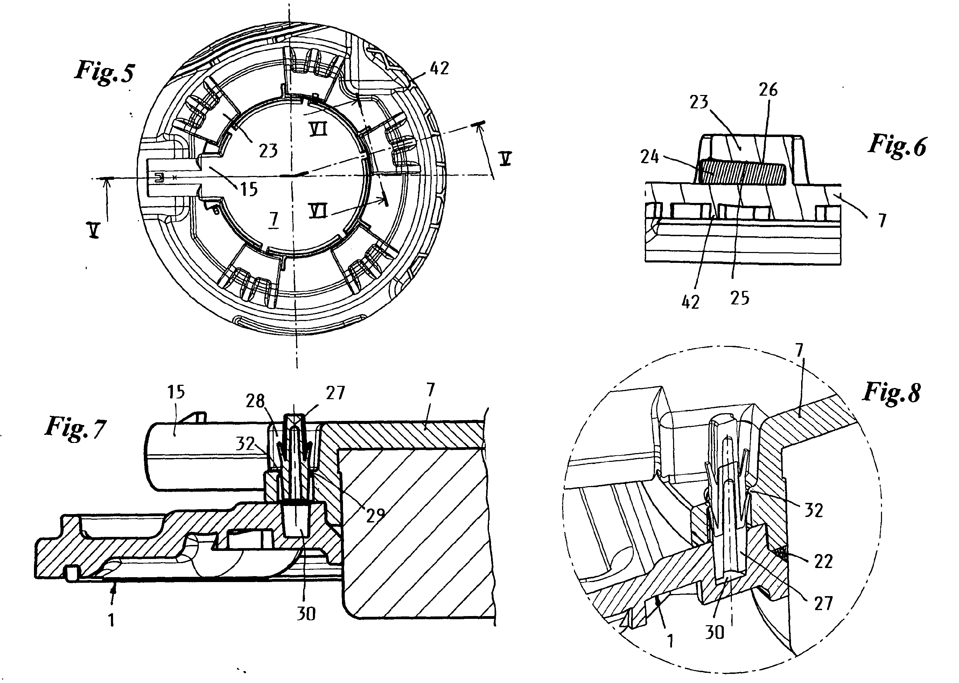

Für eine Verriegelung des Geräteträgers 7 mit der Gehäusewand 1 sind, in Umfangsrichtung des Geräteträgers 7 verteilt, an der Gehäusewand 1 mehrere Riegelaufnahmen 23 angeformt, die bockförmig von der Gehäusewand 1 abstehen. An entsprechenden Umfangsstellen des Geräteträgers 7 angeformte und radial abstehende Riegel 24 greifen in diese Riegelaufnahmen 23 ein, nachdem die somit bajonettverschlussartige Riegelverbindung nach Einsetzen des Geräteträgers 7 in die Aufnahmeöffnung 18 der Gehäusewand 1 und eine kurze Drehbewegung desselben hergestellt worden ist. Damit durch diese Drehbewegung eine spielfrei und verspannte Verbindung entsteht, verlaufen dabei in gegenseitigen Kontakt gelangende Flächen 25,26 mit Keilflächen bildender Neigung relativ zur Ebene der Gehäusewand 1 oder zur Ebene der Drehbewegung, wie die Fig.6 vergrössert zeigt.

Die Fig. 7 bis 12 zeigen drei Beispiele für eine zusätzliche Verriegelung dieser bajonettverschlussartigen Riegelverbindung.

Das Ausführungsbeispiel nach Fig.7 und 8 verwendet einen Sicherungsstift 27, der in der in Fig.7 gezeigten Ausgangsposition in einer Vertiefung 28 des Geräteträgers 7 über eine Solltrennstelle 29 im Spritzgiessverfahren angeformt ist. Nachdem die beschriebene bajonettverschlussartige Verriegelung hergestellt worden ist, befindet sich der Sicherungsstift 27 über einem in der Gehäusewand 1 vorgesehenen Sackloch 30 und lässt sich durch Niederdrücken in dieses einschieben. In dieser Endposition sind Federzungen 31 des Sicherungsstiftes 27 hinter einem nach innen gerichteten Rand 32 im Bodenbereich der Vertiefung 28 eingerastet, wie die zweite Position des Sicherungsstiftes 27 auch in Fig. 8 zeigt.

Entsprechend dem Ausführungsbeispiel nach Fig. 9 und 10 ist jeweils ein mit einer keilförmig ansteigenden Anlauffläche 33,34 versehener Rastnocken 35,36 an den sich vom Zentrierrand 17 wegerstreckenden Schulterflächen 37,38 vorgesehen. Fig.10 zeigt die somit sich ergebende Rastposition.

Beim Ausführungsbeispiel nach Fig.11 und 12 ergibt sich die Sicherung der bajonettverschlussartige Verriegelung durch eine sägezahnförmige Profilierung 39 der bei der Herstellung der Verriegelung aneinander gleitenden Keilflächen 25,26.

Um die für zwei Geräteträger 7 ausgebildete, längliche Gehäusewand 1 mit geringem Materialaufwand ausreichend steif herstellen zu können, sind ihre nicht für die Aufnahme der Geräteträger 7 benutzten Bereiche 40,41 mit zueinander wabenförmig verlaufenden Versteifungsrippen 42 versehen. Dabei sind vorzugsweise die Versteifungsrippen 42 von zwei Gerätehalter 7 ringförmig umschliessenden Bereichen 40 auf einer Seite der Gehäusewand 1 vorgesehen, während die Versteifungsrippen 42 des verbleibenden Zwischenbereichs 41 auf der gegenüberliegenden Seite der Gehäusewand 1 angeformt sind.

## Patentansprüche

1. Gehäusewand für die Befestigung eines Gerätes an einer Maschine, mit einem das Gerät (6) einschliessenden Geräteträger (7), mit mindestens einem an diesem angeformten Anschlussstutzen (15), für elektrische, pneumatische oder hydraulische Anschlüsse vom Gerät nach aussen und mit seitlichen Fortsätzen (24), für eine rüttelfeste, mechanische Verbindung des Geräteträgers (7) mit der Gehäusewand (1), **dadurch gekennzeichnet, dass** die seitlichen Fortsätze (24) des Geräteträgers (7) Riegel (24) bilden, die bajonettverschlussartig mit Riegelaufnahmen (23) der Gehäusewand (1) in Eingriff stehen.

2. Gehäusewand nach Anspruch 1, **dadurch gekennzeichnet, dass** die Gehäusewand (1) und der Geräteträger (7) in Spritztechnik aus Kunststoff gefertigt sind.

3. Gehäusewand nach Anspruch 2, **dadurch gekennzeichnet, dass** mindestens ein Bereich (40,41) zwischen dem Rand (2) der Gehäusewand (1) und dem Geräteträger (7) zueinander wabenförmig verlaufende Versteifungsrippen (42) aufweist.

4. Gehäusewand nach Anspruch 3, **dadurch gekennzeichnet, dass** die Gehäusewand (1) zwei Geräteträger (7) aufweist, wobei die somit zwei mit Versteifungsrippen (42) versehenen ringförmigen Bereiche (40) auf einer Seite der Gehäusewand (1) vorgesehen sind und mindestens ein anderer, wabenförmig verlaufende Versteifungsrippen (40) aufweisender Zwischenbereich (41) sich auf der anderen Seite der Gehäusewand (1) befindet

5. Gehäusewand nach einem der Ansprüche 1 bis 4, **dadurch gekennzeichnet, dass** die Eingriffsposition der Riegel (24) durch Verriegelungsmittel (27; 35,36; 37) gesichert ist.

6. Gehäusewand nach Anspruch 5, **dadurch gekennzeichnet, dass** zur Verriegelung der Eingriffsposition ein Sicherungsstift (27) vorgesehen ist, der in ein Sackloch (30) der Gehäusewand (1) eingreift.

7. Gehäusewand nach Anspruch 5, **dadurch gekennzeichnet, dass** in einem Randbereich der bei der Ausführung einer verriegelnden Drehbewegung des Geräteträgers (7) an aneinander gleitenden Flächen (37,38) jeweils ein mit einer keilförmig ansteigenden Anlauffläche (33,34) versehener Rastnocken (35,36) vorgesehen ist.

8. Gehäusewand nach Anspruch 5, **dadurch gekennzeichnet, dass** zur Sicherung der bajonettverschlussartigen Verriegelung an bei der Ausführung einer verriegelnden Drehbewegung des Geräteträgers (7) aneinander gleitenden Keilflächen (23,24) eine sägezahnförmige Profilierung (37) vorgesehen ist.

9. Gehäusewand nach Anspruch 1, **dadurch gekennzeichnet, dass** zwischen dem Geräteträger (7) und der Gehäusewand (1) ein Dichtring (22) angeordnet ist.
